# FASCICULE DE BREVET EUROPEEN

(11) **EP 1 437 215 B1**
(45) Date de publication et mention de la délivrance du brevet: **13.04.2016**
(21) Numéro de dépôt: 03104456.3
(22) Date de dépôt: 28.11.2003
(51) Int. Cl.: B32B 17/10, C03C 17/23, B60Q 3/02

(54) **Vitrage comportant un élément lumineux**
Verglasung mit einem Leuchtelement
Glazing comprising a luminous element

(30) Priorité: 10.01.2003 BE 200300023
(43) Date de publication de la demande: 14.07.2004
(73) Titulaire: Lif GmbH, 72108 Rottenburg (DE)
(72) Inventeur: LEFEVRE, Hugues, 6040 Jumet (BE)
(74) Mandataire: Fritz, Edmund Lothar

(56) Documents cités:
- EP-A- 0 900 971
- EP-A- 1 053 910
- EP-A1- 1 267 029
- WO-A-03/024649
- WO-A1-2004/009349
- DE-A- 10 055 560
- DE-C- 19 854 899
- DE-U- 9 215 662
- DE-U- 29 716 214
- US-A- 5 211 466
- US-A- 5 566 384
- US-B1- 6 323 429
- "Leuchtende Bilder in Glasscheiben" HTTP:, [Online] 25 octobre 2002 (2002-10-25), XP002241074 Extrait de l'Internet: URL:www.schott.com/architecture/english/ne ws/press.html> [extrait le 2003-05-13]
- PATENT ABSTRACTS OF JAPAN vol. 0174, no. 85 (P-1605), 2 septembre 1993 (1993-09-02) & JP 5 119706 A (STANLEY ELECTRIC CO LTD), 18 mai 1993 (1993-05-18)

## Description

La présente invention concerne un vitrage, en particulier pour automobiles, comportant un premier substrat transparent, un circuit de connexion qui est réalisé à l'aide d'une couche conductrice déposée sur ce substrat transparent dans laquelle des zones ont été isolées du reste de la couche par de fines bandes isolantes, et au moins un élément lumineux constitué de diodes électroluminescentes (LED).

La surface des vitrages est de plus en plus importante dans les véhicules. Les toits automobiles en verre, de grande dimension sont de plus en plus courants.

Pour l'éclairage intérieur de l'automobile, il est d'usage d'utiliser un plafonnier avec boîtier opaque et des connexions électriques par fils. Avec des toits automobiles en verre, il se pose le problème de disposer d'un éclairage intérieur qui ne perturbe pas l'esthétique du toit transparent.

Le document DE 198 54 899 C1 divulgue un vitrage avec les charactéristiques mentionnées ci-dessus. Les diodes électroluminescentes (LED) sont disposes sur une surface d'un seul substrat transparent et par consequence elles sont sans protection contres des influences mécaniques et il on résulte une surface qui n'est pas plane.

Le document "leuchtende Bilder in Glasscheiben", HTTP: 25 octobre 2002 (2002-10-25), extrait de l'Internet: URL: www.schott.com/architecture/english/news/press.html fait mention de conduits pratiquement invisibles sur la vitre et de la protection conferee à la planche conductrice par laminage avec une vitre de protection. Des diodes individuelles sont utilisées.

La présente invention a donc pour objet de mettre à disposition un vitrage lumineux où les LED sont disposées à l'intérieur du vitrage.

La solution de cet objet se révèle par un vitrage avec les charactéristiques de la revendication 1.

Selon la présente invention le vitrage comporte un deuxième substrat transparent, un ou plusieurs intercalaires thermoplastiques, et les LED et leur circuit de connexion sont insérés entre les deux substrats transparents. L'invention utilise des diodes électroluminescentes (LED) comme éléments lumineux disposes dans un vitrage. Par vitrage, on entend tout aussi bien le toit que le pare-brise ou tout autre vitre. Or, les LED sont de petites dimensions et chacune ne fournit qu'un flux de lumière relativement limité. Il est donc nécessaire d'employer un grand nombre de LED pour obtenir une luminosité suffisante. Il n'est pas aisé de réaliser un éclairage intérieur automobile, apte à être disposé sur un des vitrages, fournissant une luminosité suffisante et homogène et qui soit économique à réaliser.

Il a été découvert qu'il est possible d'obtenir un éclairage d'intérieur automobile particulièrement esthétique qui puisse se disposer dans un vitrage feuilleté et qui soit aisé à réaliser.

La présente invention a pour objet un vitrage comportant au moins un élément lumineux constitué de diodes électroluminescentes (LED).

Suivant les applications recherchées, on utilisera au choix, des feuilles de verre clair, coloré, ou partiellement ou totalement maté, sablé, sérigraphié ou tout autre type de feuille de verre appropriée ou tout autre substrat transparent approprié tel que du polycarbonate.

Le circuit de connexion des LED est réalisé à l'aide d'une couche conductrice déposée sur le substrat dans laquelle des zones ont été isolées du reste de la couche par de fines bandes non conductrices.

Les couches conductrices transparentes, parfois légèrement colorées, déposées sur du verre, sont déjà connues pour leurs propriétés isolantes et/ou antisolaires.

Les couches conductrices typiques sont par exemple des couches à base d'oxyde métallique dope dont l'épaisseur est généralement comprise entre 0.02 et 1 µm, de préférence entre 0.2 et 0.5 µm et dont la résistance de surface peut varier entre 5 et 80 Ω/□, de preference entre 10 et 30 Ω/□. De telles couches comprennent par exemple de l'oxyde de zinc dopé à indium ou à l'aluminium, de l'oxyde d'étain dopé au fluor ou de l'oxyde d'indium dopé à l'étain (généralement connu sous l'abréviation ITO).

D'autres couches conductrices typiques sont des couches à base d'argent. Ces couches conductrices peuvent être composées d'une, de deux, voire de trois couches d'argent (ou de tout autre matériau conducteur tel que Cu, Au, ou TiN), généralement séparées par des couches de diélectrique. Pour des couches comprenant une épaisseur totale de matériau conducteur comprise entre 10 et 30 nm, la résistance de surface peut atteindre des valeurs très faibles comprises entre 1 et 5 Ω/□, de préférence entre 2 et 3 Ω/□.

Cependant, toute autre couche même plus faiblement conductrice pourrait convenir pour réaliser les connexions électriques entre les LED. La tension à appliquer devra cependant être augmentée si la résistance de la couche est plus importante.

Il est donc possible de réaliser des pistes conductrices alimentant les LED en déposant une couche conductrice à propriétés anti-solaire et/ou thermiquement isolante sur la majeure partie du vitrage et en éliminant ou modifiant ensuite la couche conductrice sur de fines bandes, par exemple par laser. Pour deposer la couche conductrice, l'une ou l'autre des techniques connues peut être utilisées, par exemple la pulvérisation cathodique sous vide ou le dépôt pyrolytique en phase vapeur.

Il est également envisageable de réaliser, en une seule étape, le dépôt de la couche conductrice et des pistes conductrices par l'utilisation de masques appropriés, éventuellement réalisé par sérigraphie.

Les fines bandes sans couche ont, de préférence, une largeur comprise entre 0.01 et 3 mm, de preference comprise entre 0.05 et 1.5 mm, et de manière encore préférée entre 0.1 et 0.8 mm. De cette manière, on peut obtenir des connexions électriques quasiment invisibles même si la couche conductrice présente une légère coloration.

Les LED sont généralement constituées d'une puce semi-conductrice, d'éléments de connexion électrique et d'une enveloppe dont les fonctions sont multiples (protection de l'oxydation et de l'humidité, dissipation de la chaleur, support mécanique).

Cette enveloppe peut présenter des dimensions suffisamment petites pour être insérée dans un vitrage feuilleté. Au vu du faible flux lumineux fourni par les LED actuelles, il serait nécessaire d'en disposer un grand nombre pour obtenir un éclairage intérieur automobile satisfaisant, et de réaliser un grand nombre de connexions électriques, ce qui rendrait le procédé de fabrication onéreux.

Il est possible de disposer de LED dont le flux lumineux est plus important mais, dans ce cas, l'intensité lumineuse de chaque LED est très important, ce qui génère alors des problèmes de surchauffe et/ou d'éblouissement.

Selon un mode de réalisation avantageux de l'invention, plusieurs puces sont disposées dans une enveloppe commune dont les dimensions sont tells que sa largeur et/ou sa longueur sont au moins 10 fois plus grandes que son épaisseur, de préférence 20 fois plus grande et de manière encore préférée 40 fois plus grande.

Cette enveloppe est de préférence réalisée dans une matière transparente ou esthétiquement compatible avec le vitrage utilisé. Il est également de preference réalisé dans une matière suffisamment souple pour lui permettre d'épouser les courbures du vitrage. Il peut avantageusement comprendre une surface diffusante qui permet de lisser la lumière émise par les différentes puces.

En particulier, l'enveloppe comporte de 5 à 100 puces, de manière préférée de 10 à 50 puces, et de manière encore préférée de 15 à 40 puces.

Cette enveloppe permet de réaliser un éclairage fournissant de 10 à 500 lumens, de manière préférée de 20 à 250 lumens et de manière encore préférée de 30 à 100 lumens de manière économique, c'est-à-dire sans devoir procéder au collage d'un grand nombre de LED et sans devoir réaliser un grand nombre de connexions électriques.

De manière préférée, l'enveloppe présente une longueur et/ou une largueur comprise entre 5 et 100 mm, de préférence entre 10 et 75 mm et de manière encore préférée entre 20 et 50 mm.

L'épaisseur de l'enveloppe est de preference inférieure ou égale à 3 mm, de manière préférée inférieure à 2 mm, inférieure à 1.2 mm, inférieure à 1 mm et de manière encore plus préférée comprise entre 0.1 et 0.7 mm.

Une telle enveloppe permet de ne réaliser que 2 contacts électriques verre/ enveloppe si la luminosité fournie par l'ensemble des puces atteint environ 50 lumens.

Selon un mode particulier de réalisation de l'invention, le vitrage comporte un interrupteur de type capacitif, actionnant l'alimentation de l'élément lumineux. Cet interrupteur est constitué d'une zone de la couche conductrice, isolée du reste de la couche conductrice, et fonctionnant comme la sonde d'un circuit capacitif.

Ceci permet de réaliser un interrupteur quasiment invisible, qui fonctionne par simple contact du doigt sur la zone isolée et qui peut être disposé à proximité de l'élément lumineux sans rompre l'esthétique du vitrage.

Selon l'invention, le vitrage est un vitrage feuilleté qui comporte deux feuilles de verre accolées à l'aide d'un ou de plusieurs intercalaires thermoplastiques (généralement de type polyvinylbutyral (PVB)), les LED et leur circuit de connexion étant insérées entre les deux feuilles de verre.

Dans ce mode de réalisation, les couches peuvent être déposées soit sur la surface intérieure d'une ou de l'autre feuille de verre, soit sur le film de PVB intercalé entre les deux feuilles de verre.

Les LED et en particulier leur enveloppe ou « package » devront résister aux conditions de temperature et de pression de l'étape d'autoclavage necessaire pour la fabrication de feuilletés (de l'ordre de 10 à 15 bars et 80 à 150 °C pendant 1 à 4 heures).

Car il est inséré dans un feuilleté, l'enveloppe ne doit pas nécessairement répondre aux exigences de protection contre l'humidité et l'oxydation qui sont généralement exigées pour les enveloppes des LED classiques et pour une utilisation sur un verre simple.

L'homme du métier pourra prévoir tout type de disposition des connexions électriques pour connecter les LED ou les puces à l'intérieur de l'enveloppe, au choix, en série, en parallèle ou prévoir une disposition mixte qui a l'avantage de fournir une luminosité homogène.

La présente invention est illustrée par les exemples de réalisation spécifique ci-dessous, ces exemples n'étant pas limitatifs, et référence étant faite aux fig. dans lesquelles,
les fig. 1 à 4 représentent, en coupe, un vitrage feuilleté comportant un élément lumineux réalisé avec une ou plusieurs LED traditionnelles ; les fig. 5 et 6 représentent un vitrage feuilleté comportant un élément lumineux réalisé avec des LED particulières;
la fig. 7 représente une vue d'ensemble d'un parebrise comportant, dans sa partie supérieure, un élément lumineux ainsi qu'une zone pour l'allumage et l'extinction de l'élément lumineux.

### Exemple 1 :

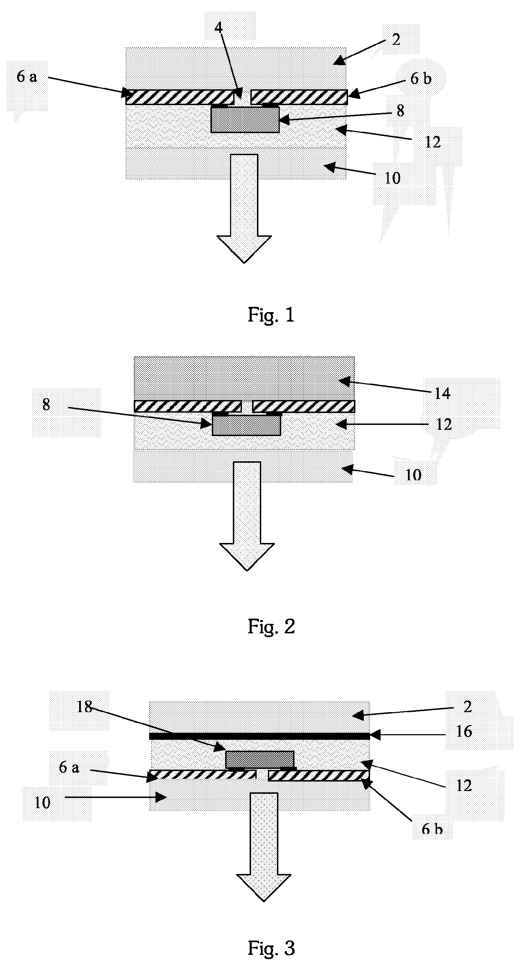

La fig. 1 représente un vitrage feuilleté réalisé comme suit. Une couche conductrice 6 (conductivité d'environ 2 Ω/□) a été déposée sur une feuille 2 de verre sodo-calcique clair de 2.1 mm d'épaisseur, destinée à être la feuille de verre extérieure du vitrage. La couche conductrice 6 est éliminée au laser sur de fines bandes 4 d'environ 0.15 mm de large, de manière à delimiter des pistes conductrices 6a, 6b. Des LED 8 dont les dimensions extérieures ne dépassent pas 0.6 mm d'épaisseur sont collées de part et d'autre d'une fine bande 4 avec une colle conductrice. Des colles conductrices typiques sont par exemple des colles à l'argent.

La feuille de verre 2 est alors laminée, face revêtue vers l'intérieur, avec une deuxième feuille 10 de verre sodo-calcique clair de manière traditionnelle, en intercalant une feuille thermoplastique double 12 de 0.72 mm d'épaisseur totale.

Pour l'exemple illustré, la colle doit être choisie pour sa résistance aux hautes températures et pression nécessaire pour réaliser le vitrage feuilleté. Elle doit aussi être choisie en fonction de sa viscosité de manière à éviter qu'elle ne se répande dans la bande isolante 4 lors du laminage du feuilleté.

Le flux lumineux émis par la LED est indiqué par la flèche. Il est orienté vers la feuille de verre intérieure 10 du vitrage.

### Exemple 2:

La fig.2 représente un vitrage feuilleté, similaire à celui de l'exemple 1, mis à part que la feuille de verre extérieure est une feuille de verre coloré 14. Ce type de verre feuilleté est particulièrement bien approprié pour réaliser un toit automobile. Sa transmission lumineuse (TL) peut ainsi être abaissée à 14 % et sa transmission énergétique (TE) à 11 %.

### Exemple 3 :

La Fig. 3 représente un vitrage feuilleté comportant une feuille de verre extérieure 2 constituée de verre clair sodo-calcique. Une couche de decoration opaque 16 est déposée sur une partie de la surface intérieure de la feuille de verre 2. La couche conductrice 6 est, dans ce cas, déposée sur la feuille de verre intérieure 10, sur sa face tournée vers intérieur du vitrage feuilleté. Des pistes conductrices 6a, 6b sont réalisées, comme aux exemples précédents, par l'élimination de la couche sur de fines bandes 4. Des LED 18, de type « reverse », c'est-à-dire prévues pour être collées par leur côté émettant la lumière, sont collées de part et d'autre des bandes 4, sur la feuille de verre intérieure 10 du vitrage.

Ce mode de réalisation permet de rendre le dispositif lumineux invisible du côté extérieur du vitrage puisque les LED 18 sont situées derrière la couche opaque 16 du vitrage.

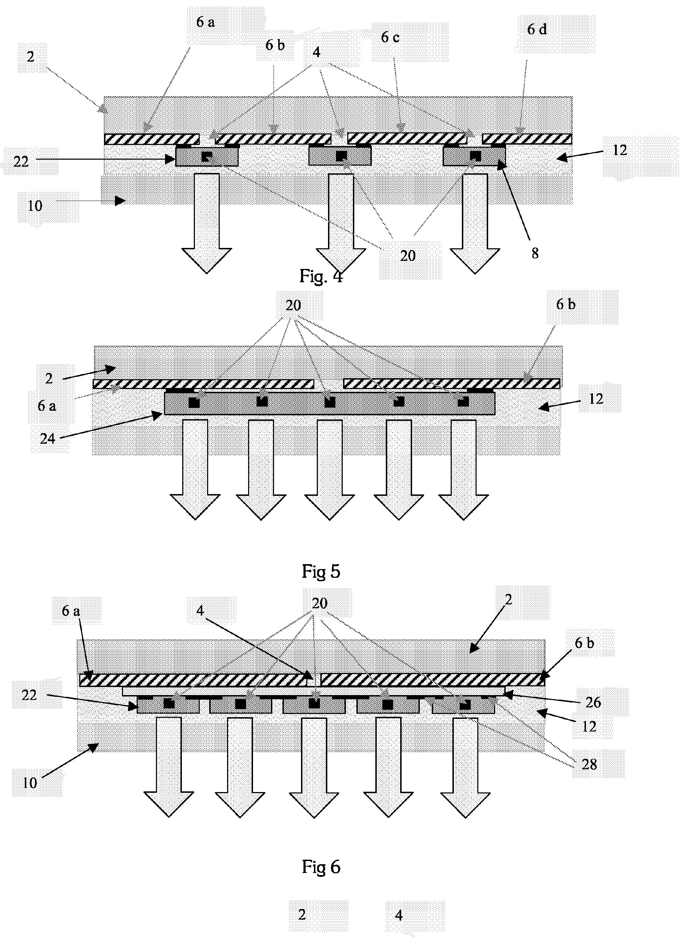

La fig. 4 représente le même mode de réalisation qu'à la fig. 2. Les LED 8 sont représentées avec une puce semi-conductrice 20 chacune encapsulée dans une enveloppe 22. Des pistes conductrices distinctes 6a, 6 d sont nécessaires pour relier chaque LED 8.

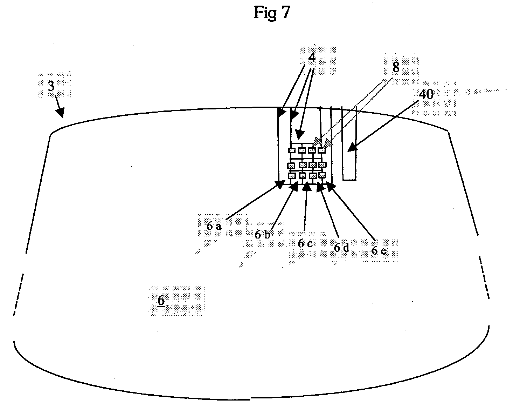

La fig. 7 représente une vue d'ensemble d'un pare-brise 34 comportant un élément lumineux constitué, dans le cas illustré schématiquement, de douze LED 8. Des pistes conductrices 6 a, 6 b, ... 6 e, délimitées par des bandes 4 où la couche 6 a été éliminée, relient chacune des LED 8 en série. Dans le cas illustré, 3 séries de 4 LED 8 sont connectées en parallèle.

La fig. 7 montre également une zone conductrice 40 délimitée par des bandes isolantes 4. Celle- ci fonctionne comme une touche capacitive et permet l'allumage et l'extinction de l'élément lumineux.

### Exemple 4 :

Le vitrage représenté à la fig. 5 comporte comme à l'exemple 1: une feuille de verre extérieure 2 revêtu d'une couche conductrice 6, un intercalaire thermoplastique 12, et une feuille de verre intérieure 10. L'élément lumineux est réalisé par l'utilisation d'une LED particulièrement adaptée pour cet usage et qui comporte une pluralité de puces semi-conductrices 20 dans une seule enveloppe 24. Ce mode de realization nécessite de réaliser moins de pistes conductrices, voir uniquement 2 pistes conductrices 6a, 6b si l'intensité lumineuse fournie par les puces semi-conductrices 20 encapsulées dans une seule enveloppe 24 est suffisante pour l'application recherchée. Ce mode de realization permet également de réaliser des bandes 4, entre les pistes conductrices 6a, 6b, plus larges et évite les risques de fluage de la colle dans les bandes isolantes.

### Exemple 5 :

Le vitrage représenté à la fig. 6 comporte comme aux exemples 1 et 4 : une feuille de verre extérieure 2 revêtu d'une couche conductrice 6, un intercalaire thermoplastique 12, et une feuille de verre intérieure 10. L'élément lumineux est réalisé par l'utilisation d'un film souple 26, par exemple en PET, sur lequel sont collées un ensemble de LED 8 constituées de leur envelope 22 encapsulant chacune une ou éventuellement plusieurs puces semi-conductrices 20. Une connexion électrique 28 est prévue sur le film 26, entre chaque envelope 22 et entre la dernière enveloppe et la couche conductrice (non représenté). Comme à l'exemple précédent, ce mode de réalisation permet de réaliser peu de pistes conductrices 6a, 6b et de réaliser des bandes 4 relativement larges, ce qui évite le fluage de la colle dans la bande 4. Le vitrage est réalisé en collant en une seule fois un ensemble de LED 8 pré-disposées sur le film 26.

Bien entendu, l'invention ne se limite pas aux exemples illustrés, et d'autres combinaisons peuvent être imaginées par l'homme du métier sans sortir du cadre de l'invention. Par exemple, les LED de type « reverse » peuvent être réalisées avec une envelope multiple contenant plusieurs puces, etc, ...

Selon l'invention, il est donc possible d'obtenir un vitrage qui comporte un élément lumineux. Les LED ont l'avantage de ne consommer que très peu d'énergie et de ne dissiper pratiquement aucune chaleur. Il est envisageable de les disposer, non seulement au pourtour du vitrage mais également sur la partie centrale ou sur une grande partie de la surface vitrée sans pour autant entraver la visibilité, si le circuit de connexion est réalisé grâce des couches conductrices transparentes et si les LED et en particulier leur enveloppe sont choisies de manière appropriée en fonction de l'application recherchée.

Les LED sont généralement monochromatiques et sont disponibles dans toutes les teintes. En insérant un grand nombre de LED, un flux lumineux (de 30 à 500 lumens) équivalent à celui d'un éclairage incandescent peut être obtenu, tout en ne nécessitant qu'une consommation bien plus faible.

## Revendications

1. Vitrage comportant un premier substrat transparent (2, 10, 14), un circuit de connexion qui est réalisé à l'aide d'une couche conductrice (6) déposée sur ce substrat transparent (2, 10, 14) dans laquelle des zones (6a, 6b, .. 6 e) ont été isolées du reste de la couche par de fines bandes isolantes (4),
le vitrage comportant un deuxième substrat transparent (2, 10),
au moins un élément lumineux constitué de diodes électroluminescentes (LED) (8, 18) et un ou plusieurs intercalaires thermoplastiques (12),
les LED (8, 18) et leur circuit de connexion étant insérés entre les deux substrats transparents.

2. Vitrage selon la revendication 1, **caractérisé en ce que** les fines bandes (4) ont des largeurs comprises entre 0.01 et 3 mm, de préférence comprise entre 0.05 et 1.5 mm, et de manière encore préférée entre 0.1 et 0.8 mm.

3. Vitrage selon l'une quelconque des revendications 1 à 2, **caractérisé en ce que** les fines bandes isotes (4) sont réalisées dans la couche conductrice (6) à l'aide d'un laser.

4. Vitrage selon l'une quelconque des revendications 2 à 3, **caractérisé en ce que** la couche conductrice (6) et les zones isolées (6 a, 6b, ..) sont réalisées par masquage ou sérigraphie.

5. Vitrage selon l'une quelconque des revendications précédentes, caractérisé en ce les LED comportent plusieurs puces semi-conductrices (20) dans une enveloppe commune (24).

6. Vitrage selon la revendication précédente, **caractérisé en ce que** les dimensions de l'enveloppe 24 sont telles que sa largeur et/ou sa longueur sont au moins 10 fois plus grandes que son épaisseur, de préférence 20 fois plus grande et de manière encore préférée 40 fois plus grande.

7. Vitrage selon l'une quelconque des revendications 5 à 6, **caractérisé en ce que** l'enveloppe (24) pré- sente une longueur et/ ou une largueur comprise entre 5 et 100 mm, de préférence entre 15 et 75 mm et de manière encore préférée entre 25 et 50 mm.

8. Vitrage selon l'une quelconque des revendications précédentes, **caractérisé en ce qu**'un interrupteur (40) actionnant l'alimentation de l'élément lumineux est constitué d'une zone de la couche conductrice (6) isolée du reste de la couche conductrice par de fines bandes (4).

9. Vitrage selon la revendication 1, **caractérisé en ce que** les LED (8, 18) ont une épaisseur inférieure ou égale à 3 mm, de manière préférée inférieure à 2 mm et de manière encore plus préférée une épaisseur comprise entre 0.1 et 1.2 mm.

10. Vitrage selon l'une quelconque des revendications précédentes, **caractérisé en ce qu**'il est un vitrage automobile et qu'il est apte à procurer un éclairage intérieur de l'habitacle de cet automobile.

## Patentansprüche

1. Verglasung umfassend ein erstes transparentes Substrat (2, 10, 14), einen Verbindungsstromkreis, der mit Hilfe einer leitenden Schicht (6) ausgeführt ist, abgeschieden auf dem transparenten Substrat (2, 10, 14), in der Zonen (6a, 6b, .. 6 e) vom Rest der Schicht isoliert wurden, mittels feiner isolierender Bänder (4), wobei die Verglasung ein zweites transparentes Substrat (2, 10) umfasst, wenigstens ein Leuchtelement, bestehend aus Leuchtdioden (LEDs) (8, 18) und eine oder mehrere thermoplastische Zwischenschichten (12),
wobei die LEDs (8, 18) und ihr Verbindungsstromkreis zwischen die beiden transparenten Substrate eingefügt sind.

2. Verglasung nach Anspruch 1, **dadurch gekennzeichnet, dass** die feinen Bänder (4) Breiten zwischen 0.01 und 3 mm haben, vorzugsweise zwischen 0.05 und 1.5 mm, und weiter vorzugsweise zwischen 0.1 und 0.8 mm.

3. Verglasung nach einem der Ansprüche 1 bis 2, **dadurch gekennzeichnet, dass** die feinen isolierenden Bänder (4) in die leitende Schicht (6) mit Hilfe eines Lasers eingebracht werden.

4. Verglasung nach einem der Ansprüche 2 bis 3, **dadurch gekennzeichnet, dass** die leitende Schicht (6) und die isolierten Zonen (6 a, 6 b, ..) durch Maskierung oder Siebdruck erstellt werden.

5. Verglasung nach einem der vorhergehenden Ansprüche, **dadurch gekennzeichnet, dass** die LEDs mehrere Halbleiter-Chips (20) in einer gemeinsamen Umhüllung (24) umfassen.

6. Verglasung nach dem vorhergehenden Anspruch, **dadurch gekennzeichnet, dass** die Abmessungen der Umhüllung (24) derart sind, dass ihre Breite und/oder ihre Länge wenigstens 10 mal so groß sind wie ihre Dicke, vorzugsweise 20 mal so groß und besonders bevorzugt 40 mal so groß.

7. Verglasung nach einem der Ansprüche 5 bis 6, **dadurch gekennzeichnet, dass** die Umhüllung (24) eine Länge und/oder eine Breite aufweist, die zwischen 5 und 100 mm liegt, vorzugsweise zwischen 15 und 75 mm und besonders bevorzugt zwischen 25 und 50 mm.

8. Verglasung nach einem der vorhergehenden Ansprüche, **dadurch gekennzeichnet, dass** ein Unterbrecher (40), der die Versorgung des Leuchtelements betreibt, aus einer Zone der leitenden Schicht (6) besteht, die von dem Rest der leitenden Schicht durch feine Bänder (4) isoliert ist.

9. Verglasung nach Anspruch 1, **dadurch gekennzeichnet, dass** die LEDs (8, 18) eine Dicke von weniger oder gleich 3 mm haben, vorzugsweise von weniger als 2 mm und weiter bevorzugt eine Dicke zwischen 0.1 und 1.2 mm.

10. Verglasung nach einem der vorhergehenden Ansprüche, **dadurch gekennzeichnet, dass** es sich um eine Verglasung eines Automobils handelt und diese geeignet ist, eine Innenbeleuchtung der Fahrgastzelle dieses Automobils zu liefern.

## Claims

1. A glazing comprising a first transparent substrate (2, 10, 14), a connection circuit which is created with the aid of a conductive layer (6) deposited on said transparent substrate (2, 10, 14), in which zones (6a, 6b, ... 6e) have been insulated from the rest of the layer by fine insulating strips (4),
the glazing comprising a second transparent substrate (2, 10),
at least one luminous element constituted by electroluminescent diodes (LED) (8, 18) and one or more thermoplastic interlayers (12),
the LEDs (8, 18) and their connection circuit being inserted between the two transparent substrates.

2. The glazing according to claim 1, **characterised in that** the fine strips (4) have widths between 0.01 and 3 mm, preferably between 0.05 and 1.5 mm, and still more preferably between 0.1 and 0.8 mm.

3. The glazing according to any one of claims 1 to 2, **characterised in that** the fine insulating strips (4) are created in the conductive layer (6) with the aid of a laser.

4. The glazing according to any one of claims 2 to 3, **characterised in that** the conductive layer (6) and the insulated zones (6a, 6b,...) are created by masking or screen-printing.

5. The glazing according to any one of the preceding claims, **characterised in that** the LEDs comprise a plurality of semiconductor chips (20) in a common envelope (24).

6. The glazing according to the preceding claim, **characterised in that** the dimensions of envelope 24 are such that its width and/or its length are at least 10 times greater than its thickness, preferably 20 times greater and still more preferably 40 times greater.

7. The glazing according to any one of claims 5 to 6, **characterised in that** the envelope (24) has a length and/or a width between 5 and 100 mm, preferably between 15 and 75 mm and still more preferably between 25 and 50 mm.

8. The glazing according to any one of the preceding claims, **characterised in that** a switch (40) activating the supply of the luminous element is constituted in a zone of the conductive layer (6) insulated from the rest of the conductive layer by the fine strips (4).

9. The glazing according to claim 1, **characterised in that** the LEDs (8, 18) have a thickness less than or equal to 3 mm, preferably less than 2 mm and still more preferably a thickness between 0.1 and 1.2 mm.

10. The glazing according to any one of the preceding claims, **characterised in that** it is a vehicle glazing and that it is capable of providing interior lighting of the passenger compartment of said vehicle.
